Europäisches Patentamt

European Patent Office

Office européen des brevets

(11) Publication number: **0 196 098 B1**

(12) **EUROPEAN PATENT SPECIFICATION**

(45) Date of publication of patent specification: **20.05.92**  (51) Int. Cl.⁵: **H03F 3/60**, H03D 7/14

(21) Application number: **86104236.4**

(22) Date of filing: **27.03.86**

(54) **Broadband Amplifier/Mixer.**

(30) Priority: **29.03.85 US 717918**

(43) Date of publication of application:
**01.10.86 Bulletin 86/40**

(45) Publication of the grant of the patent:
**20.05.92 Bulletin 92/21**

(84) Designated Contracting States:
**DE FR GB**

(56) References cited:
**US-A- 3 661 443**
**US-A- 4 446 445**

**CONFERENCE PROCEEDINGS, 14th EUROPE-AN MICORWAVE CONFERENCE 84, Liège, BE, 10th-13th September 1984, pages 483-487, Microwave Exhibitions and Publishers Ltd, Kent, GB; O.S.A. TANG et al.: "A microwave distributed MESFET mixer"**

(73) Proprietor: **HONEYWELL INC.**
**Honeywell Plaza**
**Minneapolis Minnesota 55408(US)**

(72) Inventor: **Sokolov, Vladimir**
**1424 Wood-duck Trail**
**Shakopee Minnesota 55379(US)**
Inventor: **Beyer, James B.**
**6213 Countryside Lane**
**Madison Wisconsin 53705(US)**

(74) Representative: **Herzbach, Dieter et al**
**Honeywell Europe S.A. Holding KG Patent-und Lizenzabteilung Kaiserleistrasse 55**
**Postfach 184**
**W-6050 Offenbach am Main(DE)**

Rank Xerox (UK) Business Services
(3.08/2.19/2.0)

## Description

The present invention relates to a monolithic broadband distributed amplifier/mixer. The invention is used in the art of high frequency (>1GHz) multi-octave distributed amplifier driver and combiner circuitry with gain to accomplish wideband frequency mixing. High frequency wide bandwidth monolithic distributed circuits have been known in the art for applications mainly as broadband microwave amplifiers.

A microwave broadband active mixer based on the concept of distributed amplification and using the effective input and output capacitances of MESFETs in combination with series external inductors and capacitors to form artificial transmission lines is known from CONFERENCE PROCEEDINGS, 14th EUROPEAN MICROWAVE CONFERENCE 84, Liège, BE 10th-13th September 1984, pages 483-487, Microwave Exhibitions and Publishers Ltd, Kent, GB; O.S A. TANG et al.: "A microwave distributed MESFET mixer".

Departing from this known mixer it is the object of the present invention to devise a dual distributed amplifier/mixer allowing a push-pull operation. This object is achieved according to the features of the independent claim. Further advantageous embodiments of the inventive amplifier/mixer may be taken from the dependent claims.

The inventive circuitry is compatible with GaAs monolithic integration and applicable to microwave and mm-wave systems.

With respect to the attached drawings the invention shall be further described, where

Figures 1, 1a and 1b are schematic diagrams of an embodiment of the monolithic broadband mixer according to the invention.

Figure 2 shows a simplified equivalent circuit of a MESFET operating at GHz frequencies.

Figure 3 is a schematic of another embodiment of a broadband monolithic balanced mixer using single gate FETs.

Figure 4 is a modification of Figure 3 using dual gate FETs.

Figure 5 shows an embodiment of an in-phase signal splitter.

Figure 6 shows an embodiment of a paraphase signal splitter.

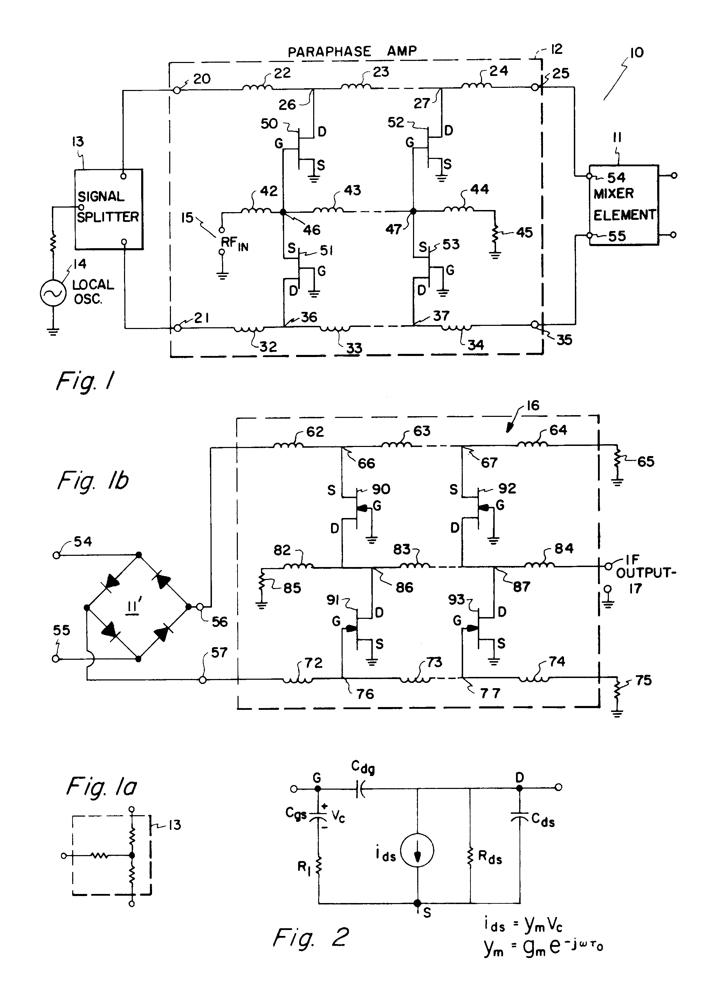

Referring now to the figures and initially to the arrangement of Figures 1, 1a and 1b there is disclosed a high frequency, (for example, 2-60GHz) broadband mixer circuit 10 which has very generally a mixer element 11, a paraphase dual distributed amplifier 12, an input signal splitter 13, a local oscillator 14, an RF input port 15, a broadband distributed combiner 16 and an IF output port 17. The signal splitter 13 receives the signal from the local oscillator, splits the signal and delivers it in the same phase to input terminals 20 and 21 of the transmission line formed by the outboard series inductances and shunt capacitances of the broadband paraphase distributed amplifier 12. In a simple passive form the signal splitter may be a resistive network like that shown in Figure 1a.

Dual distributed amplifier 12 is represented by the schematic as having two pairs of FETs but the number of cascaded pairs may vary as necessary. Input terminal 20 is shown connected through series inductive segments 22, 23 and 24 to amplifier output terminal 25. Similarly input terminal 21 is connected through series inductive segments 32, 33 and 34 to amplifier output terminal 35. RF input terminal 15 is connected through series inductive segments 42, 43 and 44 and a resistive element 45 to ground. Between segments 22 and 23 is a junction 26, and between segments 23 and 24 is a junction 27. Between segments 32 and 33 is a junction 36, and between segments 33 and 34 is a junction 37. Junctions 46 and 47 are similarly located intermediate the inductive elements 42, 43 and 44. A first FET 50 has its drain connected to junction 26, its source connected to ground, and its gate connected to junction 46. FET 50 is paired with FET 51 which has its source connected to junction 46, its drain to junction 36, and its gate connected to ground. Similarly, FET 52 has its drain connected to junction 27, its source to ground, and its gate to junction 47. It is paired with FET 53 which has its source connected to junction 47, its drain to junction 37, and its gate connected to ground. Thus the FETs 50 and 52, the inductive segments 22, 23 and 24, the common RF inductive segments 42, 43 and 44 and the associated capacitive effects shown in Figure 2 comprise the first half of the dual distributed amplifier 12. The FETs 51 and 53, the inductive segments 32, 33 and 34, the common RF inductive segments 42, 43 and 44 and the associated capacitive effects comprise the second half of the dual distributed amplifier. The output terminals 25 and 35 of the dual distributed amplifier are connected to the input terminals 54 and 55 of mixer element 11.

The present mixer is conventional in the sense of converting RF energy at one frequency into energy at another frequency to make the signal processing easier. Mixers have been conventionally classified as single-ended, single-balanced, double-balanced, and double double-balanced to name several. An example of a double-balanced mixer shown in Figure 1b is the ring modulator 11' which has output terminals 56 and 57. Terminals 56 and 57 are connected to the inputs of broadband distributed combiner 16. Terminal 56 is shown connected through series inductive segments 62, 63 and 64 and resistor 65 to ground. Terminal 57 is shown connected through series inductive segments 72, 73 and 74 and resistor 75 to ground. A common central leg terminating at IF output 17 can be traced from ground through resistor 85, and series inductive segments 82, 83 and 84. Between elements 62 and 63 is a junction 66; between elements 63 and 64 is a junction 67; between elements 72 and 73 is a junction 76; between elements 73 and 74 is a junction 77; between elements 82 and 83 is a junction 86 and between elements 83 and 84 is a junction 87. A FET 90 has its source connected to junction 66, its drain connected to junction 86 and its gate connected to ground. It is paired with FET 91 which has its drain connected to junction 86, its gate connected to junction 76, and its source connected to ground. Similarly FET 92 has its source connected to junction 67, its drain connected to junction 87 and its gate connected to ground. It is paired with FET 93 which has its drain connected to junction 87, its gate connected to junction 77 and its source connected to ground. Thus in this dual distributed combiner circuit the FETs 90 and 92, the inductive segments 62, 63 and 64, the common inductive segments 82, 83 and 84 and the associated distributed capacity including the FET capacity shown in Figure 2, comprise the first half of the distributed combiner 16. The FETs 91 and 93, the inductive segments 72, 73 and 74, the common inductive segments 82, 83 and 84 and the associated distributed capacity comprise the second half of the dual distributed signal combiner.

Figure 2 shows a simplified equivalent circuit of the MESFETs operating at the high frequencies (>1GHz) described herein. The capacitance gate-to-source, Cgs, forms a major part of the input transmission line capacitance, and the capacitance drain-to-source, Cds, forms a major part of the output transmission line capacitance. Cdg is the drain to gate capacitance, $g_m$ is the transconductance, and $i_{dc}$ represents the voltage dependent current generator function of the FET.

Looking again at the dual distributed amplifier 12 of Figure 1 it can be seen that the transistor pairs are cross bonded with each other which means the source electrode of each FET is connected to the gate of the other. In operation the same signal is fed to the drain of each of FETs 50 and 51 from the oscillator 14 while the RF signal causes opposite effects in the conductivity of FET 50 versus FET 51, for example. FET pair 52 and 53 is controlled in similar fashion. In the distributed combiner 16 of Figure 1b, a similar circuit configuration exists and the opposite signals on input terminals 56 and 57 combine at the FET pairs to provide a single IF output at 17.

The mixer itself is the non-linear element shown in block diagram 11 in Figure 1, and in a representative schematic form 11' in Figure 1b. In the prior art conventional case this mixer element is driven by a passive transformer (balun) and the output at IF is likewise combined in a passive transformer. In this invention, however, the transformers are replaced by distributed amplifiers which provide conversion gain. The driver is a distributed paraphase amplifier which allows the RF signal to be applied to the mixer element in push-pull. The paraphase output transmission lines are driven by a local oscillator signal which provides a push-push drive to the mixer element.

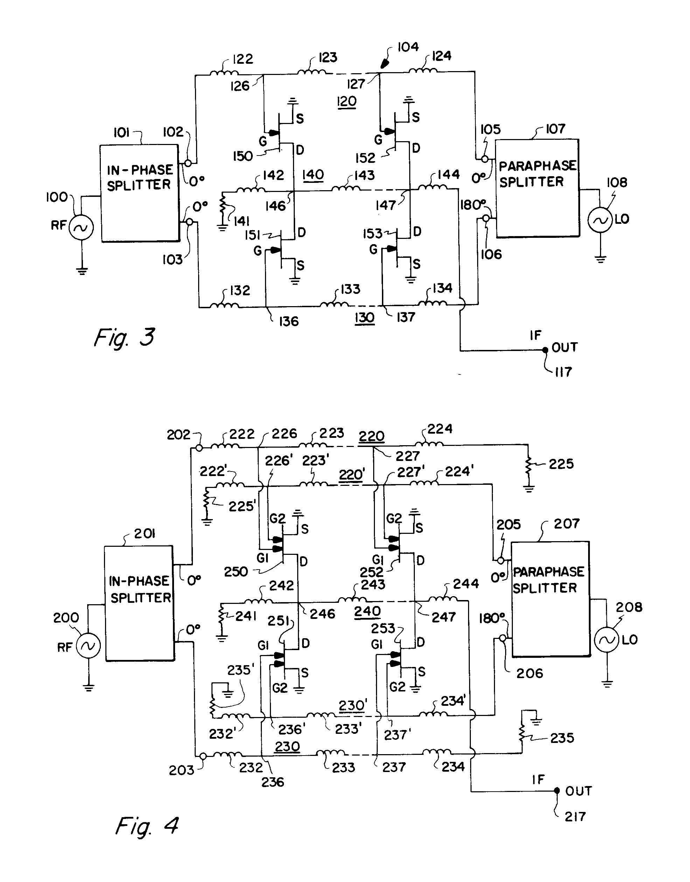

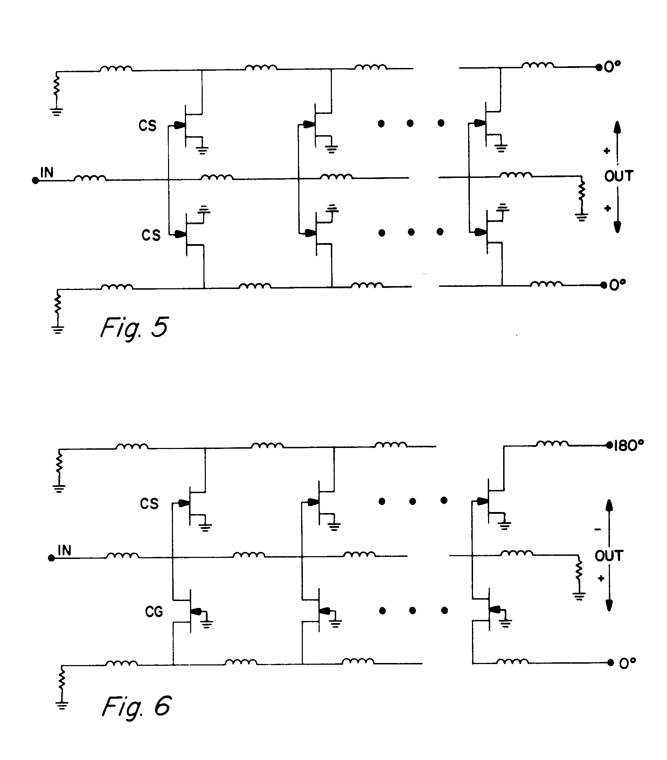

Referring now to Figure 3, there is disclosed another embodiment of the broadband monolithic dual distributed amplifier/mixer. In this figure the RF signal 100 is connected through an in-phase signal splitter 101 to RF input terminals 102 and 103 of the dual distributed amplifier/mixer generally shown at 104. In addition to the RF input terminals 102 and 103, the opposite ends of the transmission lines include input terminals 105 and 106 which are fed through a paraphase splitter 107 from a local oscillator 108. Both of the signal splitters can be active monolithic circuits using distributed circuit concepts as shown in Figures 5 and 6. A transmission line circuit 120 can be traced from terminal 102 through an inductive segment 122, a junction 126, an inductive segment 123, a junction 127, and an inductive segment 124 to the terminal 105. A similar circuit 130 can be traced from terminal 103 through an inductive segment 132, a junction 136, an inductive segment 133, a junction 137, and an inductive segment 134 to the terminal 106. A third common IF transmission line circuit 140 can be traced from ground through a resistive element 141, an inductive segment 142, a junction 146, an inductive segment 143, a junction 147, and an inductive segment 144 to IF output terminal 117. FETs 150, 151, 152 and 153 have grounded source electrodes. FET 150 has its gate connected to junction 126 and its drain connected to 146. The gate of FET 151 is connected to junction 136 and its drain to 146. The gate of FET 152 is connected to junction 127 and its drain to 147. The gate of FET 153 connects to 137 and the drain to 147.

Thus the FETs 150 and 152, the inductive segments 122, 123 and 124, the inductive segments 142, 143 and 144 and the associated capacitive effects comprise the first half of the dual distributed amplifier/mixer. The FETs 151 and 153, the inductive segments 132, 133 and 134, the common inductive segments 142, 143 and 144 and the capacity effects comprise the second half of the dual distributed amplifier/mixer. The embodiment of this Figure also provides conversion gain.

A modification of the monolithic mixer of Figure 3 is shown in Figure 4 in which dual gate FETs 250, 251, 252 and 253 are used in place of the single gate FETs of Figure 3. Separate transmission line portions 220 and 220', 230 and 230' are shown in Figure 4 and will be explained, otherwise the circuit is similar to that explained in Figure 3. A transmission line circuit 220 can be traced from in-phase splitter 201 through terminal 202, inductive segment 222, junction 226, inductive segment 223, junction 227, inductive segment 224 and resistor 225 to ground. A transmission line circuit 220' can be traced from paraphase splitter 207 through terminal 205, inductive segment 224', junction 227' and resistor 225' to ground. Gate G1 and G2 of FET 250 are connected to junctions 226 and 226', respecitvely. Gate G1 and G2 of FET 252 are connected to junctions 227 and 227', respectively.

A transmission line circuit 230 can be traced from splitter 201 through terminal 203, inductive segment 232, junction 236, inductive segment 233, junction 237, inductive segment 234 and resistor 235 to ground. A transmission line circuit 230' can be traced from paraphase splitter 207 through terminal 206, inductive segment 234', junction 237', inductive segment 233', junction 236', inductive segment 232' and resistor 235' to ground. Gates G1 and G2 of FET 251 are connected to juntions 236 and 236' respectively. Gates G1 and G2 of FET 253 are connected to junctions 237 and 237' respectively. IF output transmission line circuit 240 can be traced from ground through resistor 241, an inductive segment 242, a junction 246, an inductive segment 243, a junction 247, and an inductive segment 244 to IF output terminal 217. FETs 250 and 251 each has its drain connected to junction 246 and FETs 252 and 253 each has its drain connected to junction 247. The source electrodes of each of the four FETs is grounded.

The embodiments described in Figures 3 and 4 show a broadband mixer circuit with conversion gain which utilizes either single gate FETs 150, 151, 152 and 153 in Figure 3 or dual gate FETs 250, 251, 252 and 253 in Figure 4 for the mixing elements. The active splitters as well as the FETs used for mixing are realized as distributed amplifiers shown in Figures 5 and 6. The paraphase splitter and the in-phase splitter provides, respectively, push-pull and push-push signals of the RF signal and the local oscillator signal to drive the mixer FETs. The entire circuit is compatible for monolithic integration.

Referring again to the embodiment of Figures 1 and 1b, it will be appreciated that the mixer 11, 11', which is there shown in a ring modulator form, may also be an active distributed mixer.

**Claims**

1. A monolithic dual distributed amplifier/mixer, comprising

   a) first and second sections, the first section comprising a first artificial transmission line (120) having a plurality of inductive segments (122,123,124) distributed therealong, said first transmission line having RF input terminals (102)and local oscillator (LO) input terminals (105) connected therewith;

   b) a common IF output artificial transmission line (140) having a plurality of inductive segments (142,143,144) distributed therealong;

   c) a first plurality of FETs (150,152) in said first section each being connected between said segments of said first transmission line (120) and said segments of said common transmission line (140);

   d) a second artificial transmission line (130) within the second section having a plurality of inductive segments (132,133,134) distributed therealong, said second transmission line having RF input terminals (103) and local oscillator (LO)input terminals (106) connected therewith;

   e) a second plurality of FETs (151,153) in said second section each being connected between said segments of said second transmission line (130) and said segments of said common transmission line (140);

   wherein one of said RF and LO signals being applied in push-pull and the other of said RF and LO signals being applied in-phase to said first and second transmission lines (120,130) for frequency mixing.

2. Amplifier/mixer according to claim 1, wherein said first plurality of FETs (150,152) has the gate electrodes connected along the first of said transmission line (120) and the drain electrodes connected to said IF transmission line (140), and said second plurality of FETs (151,153) has the gate electrodes connected along the second of said transmission line means (130) and the drain electrodes connected to said IF transmission line (140).

3. Amplifier/mixer according to claim 1, wherein said plurality of FETs are single gate FETs.

4. Amplifier/mixer according to claim 1, wherein said pluralities of FETs (250-253) are dual gate FETs, and in which said first and second artificial transmission line means each has one distributed circuit (220,230) connected to the RF input terminals (202,203) and another distributed circuit (220',230') connected to the local oscillator input terminals (205,206), the one circuit being connected to a first gate of said dual gate FETs and the other circuit being connected to a second gate of said dual gate FETs.

**Revendications**

1. Amplificateur/mélangeur distribué double monolithique comprenant :

   a) des première et seconde sections, la première section comprenant une première ligne de transmission artificielle (120) qui inclut une pluralité de segments inductifs (122, 123, 124) répartis le long d'elle-même, ladite première ligne de transmission comportant des bornes d'entrée radio-fréquence (RF) (102) et des bornes d'entrée d'oscillateur local (LO) (105) connectées avec elle ;

   b) une ligne de transmission artificielle de sortie de fréquence intermédiaire (IF) commune (140) qui inclut une pluralité de segments inductifs (142, 143, 144) répartis le long d'elle-même ;

   c) une première pluralité de FETs (transistor à effet de champ) (150, 152) dans ladite première section, chacun étant connecté entre lesdits segments de ladite première ligne de transmission (120) et lesdits segments de ladite ligne de transmission commune (140) ;

   d) une seconde ligne de transmission artificielle (130) dans la seconde section qui inclut une pluralité de segments inductifs (132, 133, 134) répartis le long d'elle-même, ladite seconde ligne de transmission comportant des bornes d'entrée RF (103) et des bornes d'entrée d'oscillateur local (LO) (106) connectées avec elle ;

   e) une seconde pluralité de FETs (151, 153) dans ladite seconde section, chacun étant connecté entre lesdits segments de ladite seconde ligne de transmission (130) et lesdits segments de ladite ligne de transmission commune (140) ;

   dans lequel l'un desdits signaux RF et LO est appliqué d'une manière push-pull et l'autre desdits signaux RF et LO est appliqué en phase auxdites première et seconde lignes de transmission (120, 130) pour effectuer le mélange de fréquences.

2. Amplificateur/mélangeur selon la revendication 1, dans lequel ladite première pluralité de FETs (150, 152) a les électrodes de grille connectées le long de ladite première ligne de transmission (120) et les électrodes de drain connectées à ladite ligne de transmission IF (140), et ladite seconde pluralité de FET (151, 153) a les électrodes de grille connectées le long de ladite seconde ligne de transmission (130) et les électrodes de drain connectées à ladite ligne de transmission IF (140).

3. Amplificateur/mélangeur selon la revendication 1, dans lequel ladite pluralité de FETs a des FETs à grille unique.

4. Amplificateur/mélangeur selon la revendication 1, dans lequel la pluralité de FETs (250-253) a des FET à double grille et dans lequel lesdites première et seconde lignes de transmission artificielles comportent chacune un circuit distribué (220, 230) qui est connecté aux bornes d'entrée RF (202, 203) et un autre circuit distribué (220', 230') qui est connecté aux bornes d'entrée d'oscillateur local (205, 206), l'un de ces circuits étant connecté à une première grille desdits FETs à double grille et l'autre de ces circuits étant connecté à une seconde grille desdits FETs à double grille.

**Patentansprüche**

1. Monolithischer dual verteilter Verstärker/Mischer, umfassend:

   a) erste und zweite Abschnitte, wobei der erste Anbschnitt eine erste übertragungs-Kettenleitung (120) mit mehreren entlang verteilten induktiven Segmenten (122,123,124) aufweist und die erste übertragungsleitung mit ihr verbundene HF-Eingangsanschlüsse (102) und lokale Oszillator (LO)-Eingangsanschlüsse aufweist;

   b) eine gemeinsame Zf-Ausgangs-übertragungs-Kettenleitung (140) mit mehreren entlang verteilten induktiven Segmenten (142,143,144);

   c) erste mehrere FET's (150,152) in dem ersten Abschnitt, wobei jeder zwischen den Segmenten der ersten übertragungsleitung (120) und den Segmenten der gemeinsamen übertragungsleitung (140) angeordnet ist;

   d) eine zweite übertragungs-Kettenleitung (130) innerhalb des zweiten Abschnittes mit mehreren entlang verteilten induktiven Segmenten (132,133,134), wobei die zweite übertragungsleitung mit ihr verbundene HF-Eingangsanschlüsse (103) und lokale Oszillator (LO)-Eingangsanschlüsse aufweist;

   e) zweite mehrere FET's (151,153) in dem zweiten Abschnitt, wobei jeder zwischen den Segmenten der zweiten übertragungsleitung (130) und den Segmenten der gemeinsamen übertragungsleitung (140) angeordnet ist; wobei eines der HF- und LO-Signale im Gegentakt und das andere der HF- und LO-Signale gleichphasig an die ersten und zweiten übertragungsleitungen (120,130) zur Frequenzmischung angelegt wird.

2. Verstärker/Mischer nach Anspruch 1, wobei von den ersten mehreren FET's (150,152) die Steuerelektroden an die erste übertragungsleitung (120) und die Senkenelektroden an die ZF-übertragungsleitung (140) angeschlossen sind und wobei von den zweiten mehreren FET's (151,153) die Gatterelektroden an die zweite übertragungsleitung (130) und die Senkenelektroden an die ZF-übertragungsleitung (140) angeschlossen sind.

3. Verstärker/Mischer nach Anspruch 1, wobei die mehreren FET's eine einzige Steuerelektrode aufweisen.

4. Verstärker/Mischer nach Anspruch 1, wobei die mehreren FET's (250-253) zwei Steuerelektroden aufweisen und wobei die ersten und zweiten Ketten-übertragungsleitungen jeweils einen ersten verteilten Schaltkreis (220,230), der an die HF-Eingangsanschlüsse (202,203) angeschlossen ist, und einen anderen verteilten Schaltkreis (220',230'), der an die Eingangsanschlüsse des lokalen Oszillators angeschlossen ist, aufweisen, wobei der eine Schaltkreis an eine erste Steuerelektrode der FET's mit zwei Steuerelektroden und der andere Schaltkreis an eine zweite Steuerelektrode der FET's mit zwei Steuerelektroden angeschlossen ist.

Fig. 1

Fig. 1b

Fig. 1a

Fig. 2

$$i_{ds} = y_m V_c$$
$$y_m = g_m e^{-j\omega\tau_0}$$

Fig. 3

Fig. 4

Fig. 5

Fig. 6